# FASCICULE DE BREVET EUROPEEN

(11) **EP 0 361 295 B1**
(45) Date de publication et mention de la délivrance du brevet: **15.12.1993**
(21) Numéro de dépôt: 89117372.6
(22) Date de dépôt: 20.09.1989
(51) Int. Cl.: H03B 19/14

(54) **Diviseur de fréquence pour micro-ondes**
Mikrowellen-Frequenzteiler
Microwave frequency divider

(30) Priorité: 22.09.1988 FR 8812383
(43) Date de publication de la demande: 04.04.1990
(73) Titulaire: ALCATEL TELSPACE, 92734 Nanterre Cédex (FR)
(72) Inventeur: Levy, Philippe, F-02400 Château-Thierry (FR)
(74) Mandataire: Weinmiller, Jürgen

(56) Documents cités:
- EP-A- 0 025 894
- IEEE TRANSACTIONS ON MICROWAVE THEORY AND TECHNIQUES, vol. MTT-32, no. 11, novembre 1984, pages 1461-1468, IEEE, New York, US; C. RAUSCHER: "Regenerative frequency division with a GaAs FET"
- CONFERENCE PROCEEDINGS OF THE 16TH EUROPEAN MICROWAVE CONFERENCE, Dublin, 8-12 septembre 1986, pages 749-753, Microwave Exhibitions and Publishers Ltd, Tunbridge Wells, Kent, GB; S.P. STAPLETON et al.: "A microwabe frequency halver with conversion gain"
- ELECTRONICS LETTERS, vol. 23, no. 20, 24 septembre 1987, pages 1085-1087, Stevenage, Herts, GB; I. KIPNIS: "20GHz frequency-divider silicon biopolar MMIC"

## Description

La présente invention se rapporte à un diviseur de fréquence par deux, destiné au domaine des hyperfréquences.

On connaît, en matière de diviseurs de fréquences utilisables en micro-ondes, des diviseurs logiques et des diviseurs analogiques.

Les diviseurs logiques rapides, qui sont généralement à composants monolithiques à l'Arséniure de Gallium ou au Silicium, ont pour inconvénients d'être onéreux, sensibles aux tensions d'alimentation, et de présenter une dérive non négligeable en température.

Les diviseurs analogiques à diodes varactor ou à diodes de commutation rapide ont pour inconvénients de nécessiter des puissances d'entrée relativement élevées, généralement supérieures à 30 milliwatts, de couvrir une bande assez étroite, et de manquer de dynamique d'entrée du fait que les variations possibles du niveau d'entrée sont assez limitées. Ces diviseurs doivent en outre être placés dans un boîtier fraisé qui leur est propre.

Il est possible dans certains cas d'utiliser un oscillateur subharmonique synchronisé, mais la présence permanente d'un signal de sortie de fréquence libre peut être préjudiciable au bon fonctionnement de l'équipement dans lequel il est inséré.

L'invention vise à remédier à ces inconvénients. Elle se rapporte à cet effet à un diviseur de fréquence par deux pour onde hyperfréquence, ce diviseur étant de type analogique. Ce diviseur de fréquence comporte un transistor monté en amplificateur, avec son point de fonctionnement situé dans la partie non linéaire de sa caractéristique. Son circuit d'entrée (de base ou de grille) comporte deux selfs à ruban, ou "microstrip", dont une première self placée en série, entre la borne d'entrée du signal hyperfréquence et la base ou grille (électrode de commande) du transistor, et une seconde self ajustable branchée en parallèle, entre cette borne d'entrée et la masse. La première self est prévue pour définir, en combinaison avec la capacité parasite entre l'électrode de commande et l'électrode de sortie du transistor, une boucle de retour sélective dont la fréquence de filtrage est réglée sur la fréquence moitié de la fréquence d'entrée. La seconde self est réglée pour que la phase du signal réinjecté par la boucle de retour précitée soit telle que ce signal réinjecté est soustrait du signal d'entrée.

Avantageusement en outre, un filtre adaptateur de sortie est placé dans le circuit de sortie du transistor, ce filtre étant réglé sur la fréquence moitié du signal d'entrée. Ce filtre de sortie est avantageusement un filtre de bande centré sur cette fréquence moitié et dont la largeur de bande permet de couvrir environ une octave. Il est préférentiellement constitué d'une capacité branchée entre l'électrode de sortie du transistor et la masse, et de deux selfs réalisées sous forme de ruban, ou "microstrip" :
- une première self branchée entre cette électrode de sortie et la borne de sortie hyperfréquence du diviseur ;
- une deuxième self branchée entre cette borne de sortie et la masse.

De toute façon, l'invention sera bien comprise, et ses avantages et autres caractéristiques ressortiront, au cours de la description suivante d'un exemple non limitatif de réalisation, en référence au dessin schématique annexé dans lequel :
- Figure 1 est le schéma de principe utilisé pour ce diviseur de fréquence ;
- Figure 2 est un schéma électrique de ce diviseur de fréquence ; et
- Figure 3 illustre la réalisation et le réglage des deux selfs placées dans le circuit d'entrée du transistor utilisé pour ce diviseur de fréquence.

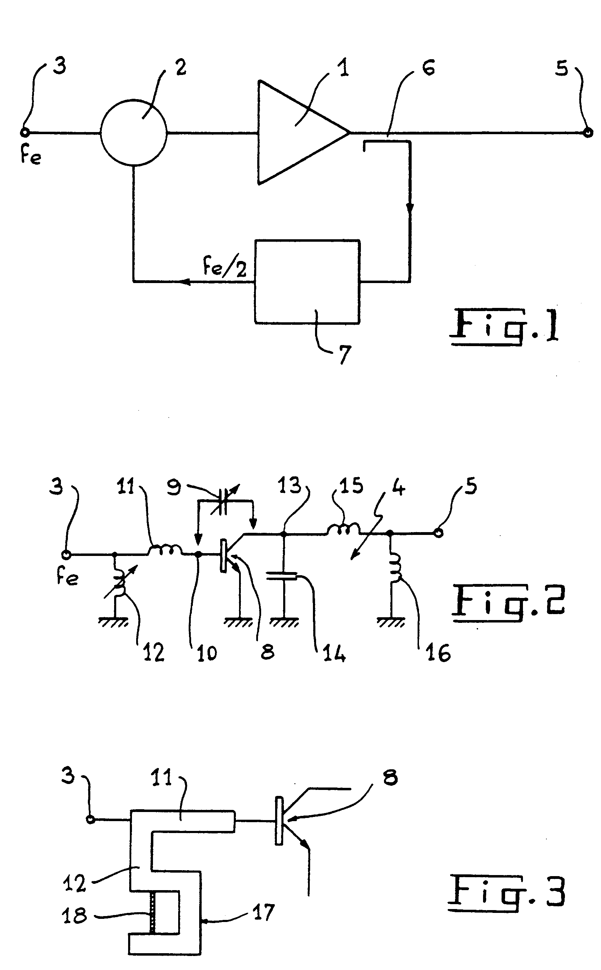

La figure 1 est un schéma-blocs d'un diviseur de fréquence par deux, connu en soi et dont le principe général de fonctionnement est utilisé dans la réalisation conforme à l'invention.

Sur cette figure, la référence 1 désigne un amplificateur à grand gain comportant un filtre réglé sur la fréquence moitié du signal d'entrée. Cet amplificateur est alimenté par le signal d'entrée à fréquence fe (borne d'entrée 3) à travers un additionneur 2. Le signal de sortie de cet amplificateur 1 alimente la borne de sortie 5 du diviseur de fréquence.

Sur la sortie de cet amplificateur 1 est aussi branché un coupleur 6 qui forme l'entrée d'une boucle de retour comportant un circuit 7 qui est à la fois un filtre très sélectif réglé sur la fréquence fe/2 et un circuit à déphasage réglable.

En sortie du circuit 7, on trouve donc un signal à fréquence fe/2 qui est appliqué, avec un déphasage réglé à la valeur π, à l'additionneur 2.

Ce circuit constitue un diviseur de fréquence à boucle de retour, et c'est son principe général, en soi connu, qui est utilisé pour le diviseur hyperfréquence conforme à l'invention, selon la figure 2 à laquelle on se référera maintenant.

Ce circuit comporte un transistor bipolaire 8, du type hyperfréquence grand public tel que celui disponible dans le commerce sous la référence NE 64535. Ce transistor 8 est monté en émetteur commun. Il possède une capacité parasite collecteur-base 9, dont la valeur varie en fonction de l'amplitude instantanée du signal hyperfréquence d'entrée à fréquence fe, appliqué à la borne d'entrée 3.

Entre la borne 3 et la base 10 du transistor 8 est branchée un première self 11, réalisée en microstrip, qui, en combinaison avec la capacité 9, forme un filtre de boucle de retour sélectif et réglé sur la fréquence moitié fe/2. Une second self 12, également réalisée en microstrip, est branchée entre la borne 3 et la masse. Cette self 12 a pour rôle d'ajuster la phase du signal de retour, afin de la rendre égale à π, comme pour le circuit de la figure 1. Le transistor 8 est polarisé et chargé pour que son point de fonctionnement soit situé dans la zone non linéaire (parabolique) de sa caractéristique base-émetteur I_{B}, V_{BE}, où I_{B} est le courant de base et V_{BE} la tension base-émetteur. A sa sortie apparaissent donc les deux produits d'intermodulation, à fréquences fe+fe/2 et fe-fe/2, qui sont réinjectés vers l'entrée 3 de l'amplificateur à grand gain que constitue le transistor 8 par l'intermédiaire du filtre ajustable que constitue la capacité parasite 9 et la self 11. Ce filtre ayant sa fréquence de passage réglée sur fe/2, il s'ensuit qu'il ne laisse passer que cette composante, de sorte que, la phase de retour étant réglée à π par ajustement de la self 12, on retrouve sensiblement dans ce circuit très simple, le schéma de principe de la figure 1, où les circuits 6 et 7 sont remplacés par les éléments réactifs 9, 11 et 12.

Un signal à fréquence fe/2 apparaît finalement sur la borne de sortie 13 du transistor 8. Afin de n'obtenir sur la sortie 5 que ce signal à fréquence fe/2, un filtre 4 centré sur fe/2 est inséré entre les bornes 13 et 5. Ce filtre 4 comporte une capacité 14, branchée entre le collecteur du transistor 8 et la masse et réalisée sous forme de composant discret, et deux selfs 15 et 16 réalisées en microstrip, dont une self 15 entre les bornes 13 et 5 et une self 16 entre la borne 5 et la masse.

Le filtre 4 est avantageusement un filtre de bande conçu pour, bien qu'il soit centré sur la fréquence fe/2, avoir une largeur de bande lui permettant de couvrir une octave.

La figure 3 montre comment sont réalisées les deux selfs d'entrée 11 et 12 au moyen d'une ligne à ruban 17 grossièrement en forme de S.

La self 11 est formée par la branche horizontale supérieure du S, tandis que la self 12 est formée par sa partie restante, et voit sa valeur ajustée (afin de procurer un déphasage égal à π ) au moyen d'un trait de court-circuit 18 réalisé à la laque d'Argent.

Comme il va de soi, l'invention n'est pas limitée à l'exemple de réalisation qui vient d'être décrit. Il est par exemple possible d'effecteur, au moyen d'un transistor auxiliaire de commande, un contrôle du point de fonctionnement par miroir de courant, ce qui permet d'obtenir un fonctionnement correct dans une plage allant de -30°C à +60°C. Ce diviseur peut être réalisé de la même manière à l'aide d'un transistor à effet de champ, la base du transistor 8 devenant la grille de ce transistor FET, et l'émetteur et le collecteur du transistor 8 devenant respectivement la source et le drain de ce transistor FET.

## Revendications

1. Diviseur de fréquence par deux pour onde hyperfréquence comportant un transistor (8) monté en amplificateur, avec son point de fonctionnement situé dans la partie non-linéaire de sa caractéristique, le circuit de commande (de base 10 ou de grille) de ce transistor (8) comportant deux selfs à ruban (11, 12), la première self (11) étant placée en série, entre la borne d'entrée (3) du signal hyperfréquence (fe) et l'électrode de commande (base 10 ou grille) du transistor (8), caractérisé en ce que la seconde self (12) est ajustable et branchée en parallèle, entre cette borne d'entrée (3) et la masse, la première self (11) étant prévue pour définir, en combinaison avec la capacité parasite (9) entre l'électrode de commande (10) et l'électrode de sortie (13) du transistor (8), une boucle de retour sélective dont la fréquence de filtrage est réglée sur la fréquence moitié de la fréquence d'entrée (fe), et la seconde self (12) étant ajustée pour que la phase du signal réinjecté par cette bouche de retour soit telle que ce signal réinjecté est soustrait du signal d'entrée.

2. Diviseur de fréquence selon la revendication 1, caractérisé en ce que les deux self (11, 12) sont formées à partir d'une ligne à ruban (17) grossièrement en forme de S.

3. Diviseur de fréquence selon l'une des revendications 1 ou 2, caractérisé en ce qu'il comporte en outre un filtre adaptateur de sortie (4) qui est réglé sur la fréquence moitié du signal d'entrée (fe).

4. Diviseur de fréquence selon la revendication 3, caractérisé en ce que le filtre adaptateur de sortie (4) a une largeur de bande lui permettant de couvrir environ une octave.

5. Diviseur de fréquence selon l'une des revendications 3 ou 4, caractérisé en ce que ce filtre adaptateur de sortie est constitué d'une capacité (14) branchée entre l'électrode de sortie (13) du transistor (8) et la masse, et de deux selfs réalisées sous forme de ruban, dont :
- une première self (15) branchée entre cette électrode de sortie (13) et la borne de sortie hyperfréquence (5) du diviseur ; et
- une deuxième self (16) branchée entre cette borne de sortie (5) et la masse.

## Claims

1. A microwave frequency divider for halving frequency, the divider comprising a transistor (8) connected as an amplifier having its operating points situated in the non-linear portion of its characteristic, the control circuit (base 10 or gate) of the transistor (8) including two microstrip inductors (11, 12), with the first inductor (11) being connected in series between the input terminal (3) for the microwave signal (fe) and the control electrode (base 10 or gate) of the transistor (8), the divider being characterized in that the second inductor (12) is adjustable and is connected in parallel between said input terminal (3) and ground, the first inductor (11) being provided, in combination with the stray capacitance (9) between the control electrode (10) and the output electrode (13) of the transistor (8) to define a selective feedback loop whose filter frequency is tuned to half the input frequency (fe), and the second inductor (12) is adjusted so that the phase of the signal reinjected by this feedback loop is such that said reinjected signal is subtracted from the input signal.

2. A frequency divider according to claim 1, characterized in that the two inductors (11, 12) are constituted by means of a roughly S-shaped microstrip (17).

3. A frequency divider according to claim 1 or 2, characterized in that it further includes an output matching filter (4) which is tuned to half the frequency of the input signal (fe).

4. A frequency divider according to claim 3, characterized in that the output matching filter (4) has a bandwidth enabling it to cover about one octave.

5. A frequency divider according to claim 3 or 4, characterized in that the output matching filter is constituted by a capacitance (14) connected between the output electrode (13) of the transistor (8) and ground, and by two inductors implemented in the form of a microstrip, in which:
a first one of the inductors (15) is connected between said output electrode (13) and the microwave output terminal (5) of the divider; and
the second inductor (16) is connected between said output terminal (5) and ground.

## Patentansprüche

1. Frequenzhalbierer für Mikrowellen, mit einem als Verstärker geschalteten Transistor (8), dessen Arbeitspunkt im nichtlinearen Teil seiner Kennlinie liegt, wobei der Steuerkreis (Basis 10 bzw. Gate) dieses Transistors (8) zwei Induktivitäten (11, 12) in Bandform aufweist, von denen die erste Induktivität (11) in Reihe zwischen die Eingangsklemme (3) des Mikrowellensignals (fe) und die Steuerelektrode (Basis 10 bzw. Gate) des Transistors (8) eingefügt ist, dadurch gekennzeichnet, daß die zweite Induktivität (12) abstimmbar und parallel zwischen dieser Eingangsklemme (3) und Masse geschaltet ist, während die erste Induktivität (11) dem Zweck dient, in Kombination mit der parasitären Kapazität (9) zwischen der Steuerelektrode (10) und der Ausgangselektrode (13) des Transistors (8) eine selektive Rückkopplungsschleife zu definieren, deren Filterfrequenz auf die halbe Frequenz der Eingangsfrequenz (fe) eingestellt ist, während die zweite Induktivität (12) so eingestellt ist, daß die Phase des durch die Rückkopplungsschleife rückgeführten Signals so bemessen ist, daß das rückgeführte Signal vom Eingangssignal subtrahiert wird.

2. Frequenzteiler nach Anspruch 1, dadurch gekennzeichnet, daß die beiden Induktivitäten (11, 12) aus einer annähernd in Form eines S ausgebildeten Bandleitung (17) bestehen.

3. Frequenzteiler nach Anspruch 1 oder 2, dadurch gekennzeichnet, daß er weiter ein Ausgangsanpassungsfilter (4) aufweist, das auf die halbe Frequenz des Eingangssignals (fe) eingestellt ist.

4. Frequenzteiler nach Anspruch 3, dadurch gekennzeichnet, daß das Ausgangsanpassungsfilter (4) eine Bandbreite besitzt, die es ihm ermöglicht, ungefähr eine Oktave abzudecken.

5. Frequenzteiler nach einem der Ansprüche 3 oder 4, dadurch gekennzeichnet, daß das Ausgangsanpassungsfilter aus einem Kondensator (14), der zwischen die Ausgangselektrode (13) des Transistors (8) und Masse geschaltet ist, und zwei Induktivitäten besteht, die in Form eines Bandes ausgebildet sind, nämlich:
- eine erste Induktivität (15), die zwischen die Ausgangselektrode (13) und die Mikrowellenausgangsklemme (5) des Teilers geschaltet ist; und
- eine zweite Induktivität (16), die zwischen die Ausgangsklemme (5) und Masse geschaltet ist.
